# EUROPEAN PATENT SPECIFICATION

(11) **EP 3 316 289 B1**
(45) Date of publication and mention of the grant of the patent: **08.09.2021**
(21) Application number: 17199137.5
(22) Date of filing: 30.10.2017
(51) Int. Cl.: H01L 21/8238, H01L 27/092, H01L 29/49, H01L 21/28

(54) **METHOD TO IMPROVE THE QUALITY OF A HIGH-K DIELECTRIC LAYER**
VERFAHREN ZUR VERBESSERUNG DER QUALITÄT EINER HIGH-K DIELEKTRISCHEN SCHICHT
PROCÉDÉ POUR AMÉLIORER LA QUALITÉ D'UNE COUCHE DIELECTRIQUE À PERMITTIVITÉ K ÉLEVÉE

(30) Priority: 31.10.2016 CN 201610927451
(43) Date of publication of application: 02.05.2018
(73) Proprietor: Semiconductor Manufacturing International (Shanghai) Corporation, Shanghai 201203 (CN); Semiconductor Manufacturing International (Beijing) Corporation, Beijing 100176 (CN)
(72) Inventor: LI, Yong, Shanghai 201203 (CN)
(74) Representative: Klunker IP Patentanwälte PartG mbB

(56) References cited:
- EP-A1- 3 258 500
- US-A1- 2002 006 585
- US-A1- 2013 299 918
- US-A1- 2014 001 543
- US-A1- 2014 061 813
- US-A1- 2016 027 664
- US-A1- 2016 086 805
- US-B1- 7 732 344
- US-B1- 9 337 104
- Ana Farkhanda ET AL: "Gate Workfunction Engineering for Deep Sub-Micron MOSFET's: Motivation, Features and Challenges", IJECT Vol. 2, Issue 4, Oct . - Dec . 2011, December 2011 (2011-12), pages 2230-7109, XP055481319, Retrieved from the Internet: URL:http://www.iject.org/vol2issue4/farkha nda.pdf [retrieved on 2018-06-05]
- COUET S ET AL: "Co interaction on ZnO(000-1) investigated by scanning tunneling microscopy", APPLIED PHYSICS A; MATERIALS SCIENCE & PROCESSING, SPRINGER, BERLIN, DE, vol. 88, no. 1, 18 April 2007 (2007-04-18) , pages 111-117, XP019515462, ISSN: 1432-0630, DOI: 10.1007/S00339-007-3972-2

## Description

### TECHNICAL FIELD

The present invention relates to semiconductor technology. More particularly, embodiments of the present invention provide a method of manufacturing a semiconductor device.

### BACKGROUND

In a manufacturing process of a semiconductor device including an NMOS device and a PMOS device, it is often necessary to adjust the work function of the gate using a work function adjustment layer. A typical manufacturing process generally includes the steps of depositing a high-k dielectric layer on the NMOS and PMOS regions, depositing a P-type work function adjustment layer on the high-k dielectric layer, depositing a mask layer (e.g., a photoresist) on the P-type work function adjustment layer , removing a portion of the mask layer on the NMOS region to expose a portion of the P-type work function adjustment layer, removing the exposed portion the P-type work function adjustment layer, and removing the mask layer on the PMOS region.

US 7 732 344 B1 discloses a method for fabricating an integrated circuit with improved performance, the method comprises: providing a substrate; forming a hard mask layer over the substrate; forming protected portions and unprotected portions of the hard mask layer; performing a first etching process, a second etching process, and a third etching process on the unprotected portions of the hard mask layer, wherein the first etching process partially removes the unprotected portions of the hard mask layer, the second etching process treats the unprotected portions of the hard mask layer, and the third etching process removes the remaining unprotected portions of the hard mask layer; and performing a fourth etching process to remove the protected portions of the hard mask layer. Said protected portions may be formed by patterning a photoresist layer on the hard mask layer. Said second etching process may then simultaneously remove the patterned photoresist layer. The third etching process comprises a wet etching process. The hard mask layer may include a single layer or multiple layers. In an embodiment, a p-type work function material is patterned using the hard mask.

US 2014/061813 A1 discloses a semiconductor device including: a semiconductor substrate including: a first region and a second region; a first high-k dielectric film pattern on the first region; a second high-k dielectric film pattern on the second region and having the same thickness as the first high-k dielectric film pattern; first and second work function control film patterns positioned on the high-k dielectric film patterns of the first region; third and fourth work function control patterns are positioned on the high-k dielectric film pattern of the second region; wherein the first work function control pattern being thicker than the third work function control pattern and the fourth work function control pattern being thicker than the second.

US 2013/299918 A1 discloses a semiconductor device including: an interlayer insulating film formed on a substrate and including a trench; a gate insulating film formed in the trench; a work function adjusting film formed on the gate insulating film in the trench along sidewalls and a bottom surface of the trench, and including an inclined surface having an acute angle with respect to the sidewalls of the trench; and a metal gate pattern formed on the work function adjusting film in the trench to fill up the trench. In an embodiment, a P type work function adjusting film is formed on an N type transistor region and on a P type transistor region, a hard mask pattern that exposes the N type transistor region and covers the P type transistor region is formed on the P type work function adjusting film, and the P type work function adjusting film on the N type transistor region is removed using the hard mask pattern. Thereafter, an N type work function adjusting film is formed on both regions.

US 9 337 104 B1 discloses a method for manufacturing a semiconductor device including: providing a substrate, a dielectric layer on the substrate, a first hard mask layer on the substrate, and a second hard mask layer on the first hard mask layer; and removing the first hard mask layer using a reactive gas that does not cause damage to the dielectric layer to improve the performance and yield of the semiconductor device.

### SUMMARY OF THE INVENTION

The present inventor has discovered that, during the removal of the mask layer using a dry etching process, because the work function adjustment layer underneath the mask layer is electrically conductive, the plasma of the dry plasma etching may cause damage to the high-k dielectric layer disposed underneath the work function adjustment layer, thereby adversely affecting the device performance.

It is an object of the present invention to provide a method of manufacturing a semiconductor device which may solve one or more of the above described problems, in particular a method of manufacturing in which damage to the high-k dielectric layer disposed underneath the work function adjustment layer may be avoided and correspondingly a semiconductor device the performance of which is correspondingly improved.

The object is achieved by the features of independent claim 1. Further embodiments are defined in the dependent claims 2-9.

The following description, together with the accompanying drawings, will provide a better understanding of the nature and advantages of the claimed invention.

### BRIEF DESCRIPTION OF THE DRAWINGS

The accompanying drawings, referred to herein and constituting a part hereof, illustrate embodiments of the invention. The drawings together with the description serve to explain the principles of the invention.
FIG. 1 is a simplified flowchart illustrating a method for manufacturing of a semiconductor device according to one embodiment of the present invention.
FIG. 2 through FIG. 14 are simplified cross-sectional views of intermediate stages of a semiconductor device manufactured by a method according to some embodiments of the present invention.

### DETAILED DESCRIPTION OF THE INVENTION

In the following description, numerous specific details are provided for a thorough understanding of the present invention. However, it should be appreciated by those of skill in the art that the present invention may be realized without one or more of these details. In other examples, features and techniques known in the art will not be described for purposes of brevity.

It should be understood that the drawings are not drawn to scale, and similar reference numbers are used for representing similar elements. Embodiments of the invention are described herein with reference to cross-section illustrations that are schematic illustrations of idealized embodiments (and intermediate structures) of the invention. The thickness of layers and regions in the drawings may be exaggerated relative to each other for clarity. Additionally, variations from the shapes of the illustrations as a result, for example, of manufacturing techniques and/or tolerances, are to be expected. Thus, embodiments of the invention should not be construed as limited to the particular shapes of regions illustrated herein, but are to include deviations in shapes that result, for example, from manufacturing.

It will be understood that, when an element or layer is referred to as "on," "disposed on," "adjacent to," "connected to," or "coupled to" another element or layer, it can be disposed directly on the other element or layer, adjacent to, connected or coupled to the other element or layer, or intervening elements or layers may also be present. In contrast, when an element is referred to as being "directly on," directly disposed on," "directly connected to," or "directly coupled to" another element or layer, there are no intervening elements or layers present between them. It will be understood that, although the terms "first," "second," "third," etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Relative terms such as "under," "below," "underneath," "over," "on," "above," "bottom," and "top" are used herein to described a relationship of one element, layer or region to another element, layer or region as illustrated in the figures. It will be understood that these terms are intended to encompass different orientations of the structure in addition to the orientation depicted in the figures. For example, if the device shown in the figures is flipped, the description of an element being "below" or "underneath" another element would then be oriented as "above" the other element. Therefore, the term "below," "under," or "underneath" can encompass both orientations of the device. Because devices or components of embodiments of the present invention can be positioned in a number of different orientations (e.g., rotated 90 degrees or at other orientations), the relative terms should be interpreted accordingly.

The terms "a", "an" and "the" may include singular and plural references. It will be further understood that the terms "comprising", "including", having" and variants thereof, when used in this specification, specify the presence of stated features, steps, operations, elements, and/or components, but do not preclude the presence or addition of one or more other features, steps, operations, elements, components, and/or groups thereof. Furthermore, as used herein, the words "and/or" may refer to and encompass any possible combinations of one or more of the associated listed items. Where a portion of a layer in a region is referred to, the entire portion of the layer in that region is meant, as illustrated in the Figures.

The use of the terms first, second, etc. do not denote any order, but rather the terms first, second, etc. are used to distinguish one element from another. Furthermore, the use of the terms a, an, etc. does not denote a limitation of quantity, but rather denote the presence of at least one of the referenced items.

Embodiments of the invention are described herein with reference to cross-section illustrations that are schematic illustrations of idealized embodiments (and intermediate structures) of the invention. The thickness of layers and regions in the drawings may be exaggerated for clarity. Additionally, variations from the shapes of the illustrations as a result, for example, of manufacturing techniques and/or tolerances, are to be expected. Thus, embodiments of the invention should not be construed as limited to the particular shapes of regions illustrated herein, but are to include deviations in shapes that result, for example, from manufacturing. For example, an implanted region illustrated as a rectangle will, typically, have rounded or curved features and/or a gradient of implant concentration at its edges rather than a discrete change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the invention.

The present invention will now be described more fully herein after with reference to the accompanying drawings, in which preferred embodiments of the invention are shown. This invention is defined in the claims and may, within the scope of the claims, be embodied in many different forms and should not be construed as limited by the embodiments set forth herein. Rather, these embodiments are provided so that this disclosure will be thorough and complete, and will fully convey the invention to those skilled in the art.

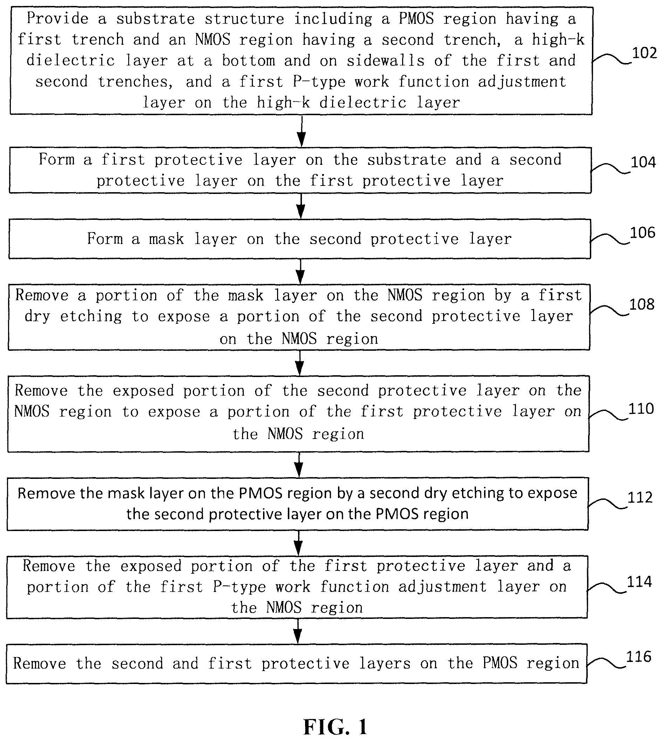

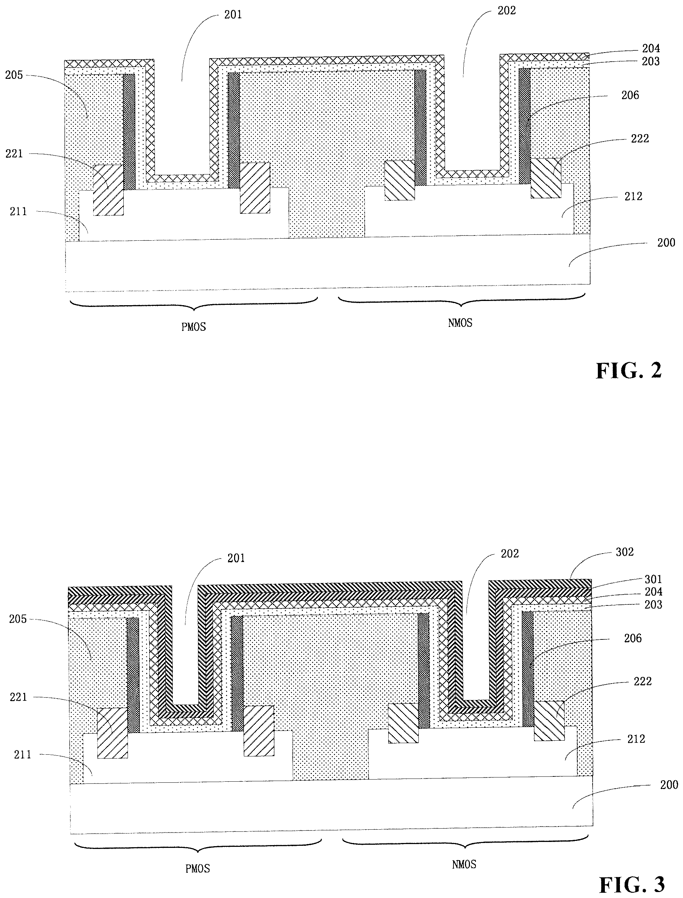

FIG. 1 is a simplified flowchart illustrating a method for manufacturing of a semiconductor device according to one embodiment of the present invention. FIG. 2 through FIG. 14 are simplified cross-sectional views of intermediate stages of a semiconductor device manufactured by a method according to some embodiments of the present invention. The manufacturing method of a semiconductor device according to embodiments of the present invention will be described in detail with reference to FIG. 1 and FIG. 2 through FIG. 14.

Referring to FIG. 1, in step 102, a substrate structure is provided.

FIG. 2 is a simplified cross-sectional view of an intermediate stage of a substrate structure according to one embodiment of the present invention. As shown in FIG. 2, the substrate structure includes a PMOS region having a first trench 201 and an NMOS region having a second trench 202 on a substrate 200. The PMOS region and the NMOS region may be isolated from each other by an isolation structure, such as a shallow trench isolation structure. A high-k dielectric layer 203 is formed at the bottom and on sidewalls of first trench 201 and second trench 202. A first P-type work function layer adjustment layer 204 is formed on high-k dielectric layer 203. In one embodiment, the substrate structure includes a first semiconductor fin 211 disposed between the substrate and the first trench, and a second semiconductor fin 212 disposed between the substrate and the second trench. In one embodiment, second and second semiconductor fins 211 and 212 are disposed on substrate 200 and in respective first and second trenches 201 and 202. A high-k dielectric layer and a first P-type work function adjustment layer are sequentially formed on the upper surface and side surfaces of first and second fins 211 and 212. In an example embodiment, the high-k dielectric layer may include, but is not limited to, other high-k dielectric materials such as hafnium oxide, tantalum oxide, aluminum oxide, zirconium oxide, or titanium oxide, and the first P-type work function adjustment layer may include, but is not limited to, TiN, TaN, or TaC. In one embodiment, the first P-type work function adjustment layer may have a thickness in the range between 20 Angstroms and 30 Angstroms, e.g., 25 Angstroms.

In one embodiment, the method for manufacturing the above-described substrate structure may include the following steps:
S1: providing an initial substrate structure including a PMOS region having a first trench 201 and an NMOS region having a second trench 202. The first and second trenches may be formed, for example, using the following steps: forming a dummy gate oxide layer on a surface of the substrate having the PMOS and NMOS regions, forming a dummy gate on the PMOS region and a dummy gate on the NMOS region, forming spacers 206 on sidewalls of the dummy gates, forming an interlayer dielectric layer 205 on the dummy gates, after forming interlayer dielectric layer 205, a planarization process is performed to expose the dummy gate in the PMOS region and the dummy gate in in the NMOS region. Thereafter, the dummy gates and the dummy gate oxide layer underneath the dummy gates are removed to form first and second trenches 201 and 202. Spacers 206 are retained on the sidewalls of first and second trenches 201 and 202. Spacers 206 may include, for example, silicon oxide, silicon nitride, silicon oxynitride, or the like.
S2: forming a high-k dielectric layer 203 (e.g., using a deposition process) on the bottom and side surfaces of first and second trenches 201 and 202. In a preferred embodiment, prior to forming high-k dielectric layer 203, an interface layer (IL), such as a thermal oxide layer by thermal oxidation, may be formed on the bottom surface of first and second trenches 201 and 202 to improve the interface property between the bottom surface of first and second trenches 201 and 202 and high-k dielectric layer 203.
S3: forming a first P-type work function dielectric layer 204 (e.g., using a deposition process) on high-k dielectric layer 203 to form the substrate structure.

In another embodiment, the method may further include, between steps S2 and S3, the following steps:
S4: forming a cap layer on high-k dielectric layer 203, e.g., using a deposition process. The cap layer may include a TiN layer and an amorphous silicon layer on the TiN layer. Thereafter, a spike annealing process may be performed at a temperature in the range between 800 °C and 1000 °C, e.g., 900 °C, 950 °C.
S5: removing the cap layer.

In this embodiment, forming the cap layer on the high-k dielectric layer and then removing the cap layer may improve the performance of the high-k dielectric layer, thereby increasing the reliability of the semiconductor device.

Further, as shown in FIG. 2, a raised source/drain region 221 and a raised source/drain region 222 are formed on opposite sides of the first semiconductor fin 211 in first trench 201 and on opposite sides of the second semiconductor fin 212 in second trench 202. In the PMOS region, raised source/drain region 221 may be formed by epitaxially growing SiGe, which may introduce compressive stress into a channel region, thereby increasing the mobility of holes. In the NMOS region, raised source/drain region 222 may be formed by epitaxially growing SiC or Si, which may introduce tensile stress into the channel region, thereby increasing the mobility of electrons.

Referring back to FIG. 1, in step 104, a first protective layer 301 and a second protective layer 302 are sequentially formed on the substrate structure, as shown in FIG. 3. In one embodiment, first protective layer 301 may include a silicon oxide, such as silicon dioxide. Second protective layer 302 may include amorphous silicon or polycrystalline silicon. In a preferred embodiment, second protective layer 302 includes amorphous silicon. It is to be understood that first protective layer 301 and second protective layer 302 are not limited to the above-described materials, and those of skill in the art may choose suitable materials as protective materials according to actual requirements. Further, first protective layer 301 has a thickness in the range between 5 Angstroms and 15 Angstroms, e.g., 10 Angstroms. Second protective layer 302 has a thickness in the range between 15 Angstroms and 25 Angstroms, e.g., 20 Angstroms.

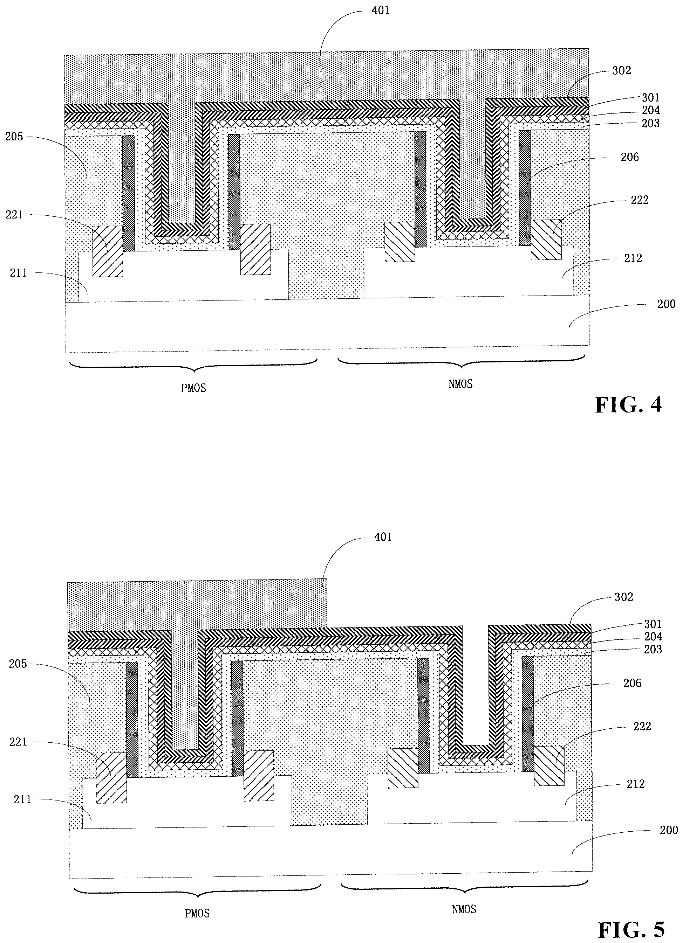

Thereafter, in step 106, a mask layer 401 is formed (e.g., by deposition) on second protective layer 302, as shown in FIG. 4. Mask layer 401 may include, for example, a photoresist. In a preferred embodiment, the bottom of the photoresist may have a bottom anti reflective coating (BARC) and the top of the photoresist may have a top anti reflective coating (TARC).

Next, in step 108, a portion of mask layer 401 on the NMOS region is removed using a dry etching process to expose a portion of second protective layer 302 on the NMOS region, as shown in FIG. 5. Because the NMOS region is protected by first protective layer 301 and second protective layer 302 while a portion of mask layer 401 on the NMOS region is removed, so that the damage caused by the dry plasma etching to the high-k dielectric layer of the NMOS is reduced.

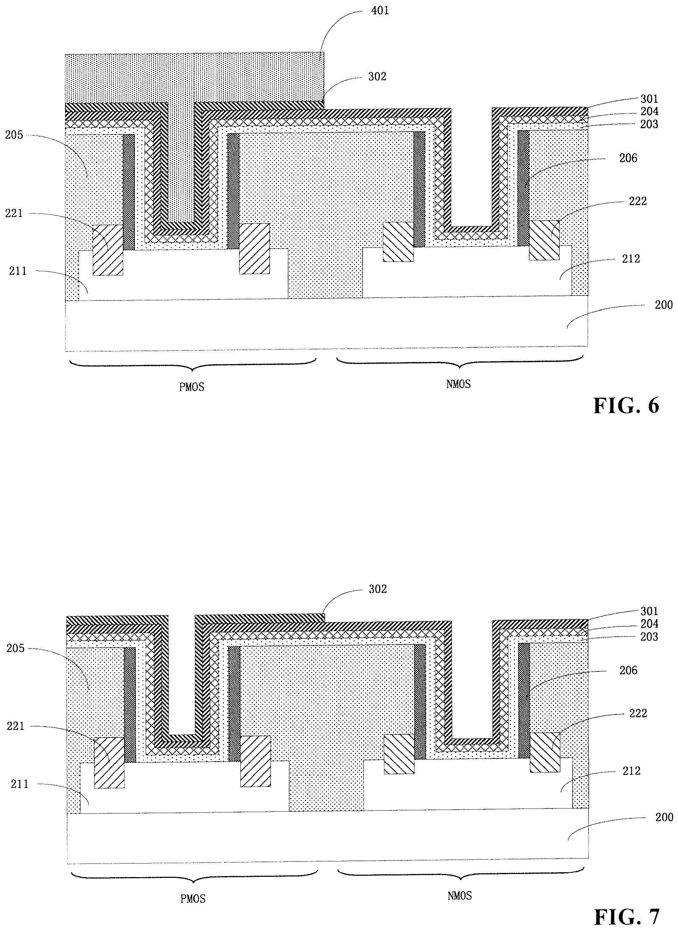

Next, in step 110, a portion of second protective layer 302 on the NMOS region is removed to expose a portion of first protective layer 301 on the NMOS region, as shown in FIG. 6. In one embodiment, the portion of second protective layer 302 on the NMOS region may be removed by a wet etching process, for example, using NH₄OH or TMAH as an etching solution.

Next, in step 112, mask layer 401 on the PMOS region is removed using a dry etching process to expose second protective layer 302 on the PMOS region, as shown in FIG. 7. Because the PMOS region is protected by first protective layer 301 and second protective layer 302 and the NMOS region is protected by first protective layer 301, the damage caused by the dry plasma etching to the high-k dielectric layer of the PMOS and NMOS regions is reduced.

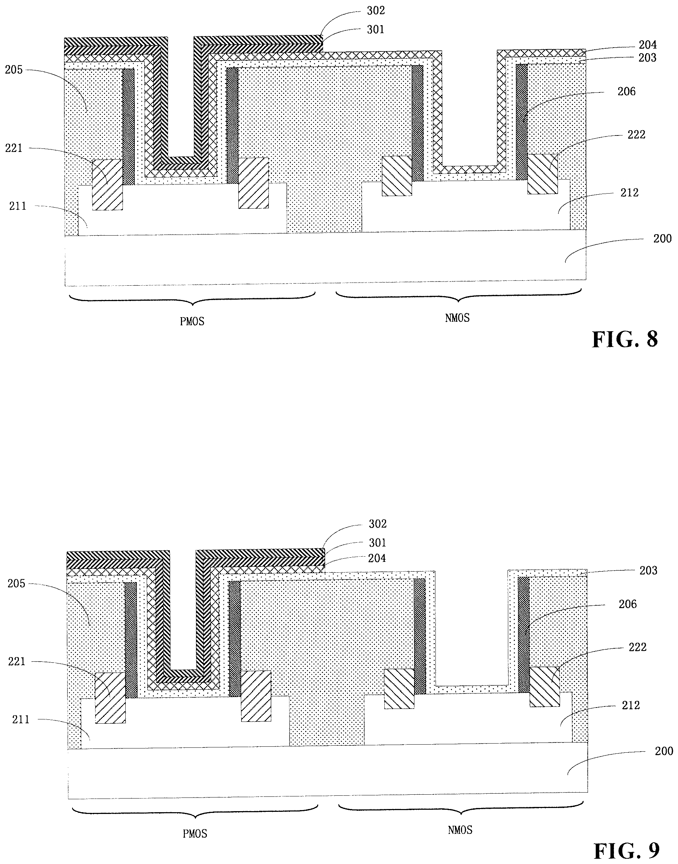

Next, in step 114, the exposed portion of first protective layer 301 on the NMOS region is removed to expose a portion of the first P-type work function adjustment layer 204 on the NMOS region, as shown in FIG. 8. Thereafter, the exposed portion of first P-type work function adjustment layer 204 on the NMOS region is removed, as shown in FIG. 9. The exposed portion of first protective layer 301 on the NMOS region is removed using a wet etching process, e.g., using dilute hydrofluoric acid (HF). In addition, the portion of first P-type work function adjustment layer 204 on the NMOS region may be removed using a SC1 or SC2 cleaning solution. Herein, the SC1 cleaning solution may include, for example, ammonium hydroxide, hydrogen peroxide, deionized water, and the like. The SC2 solution may include, for example, hydrochloric acid, hydrogen peroxide, deionized water, and the like.

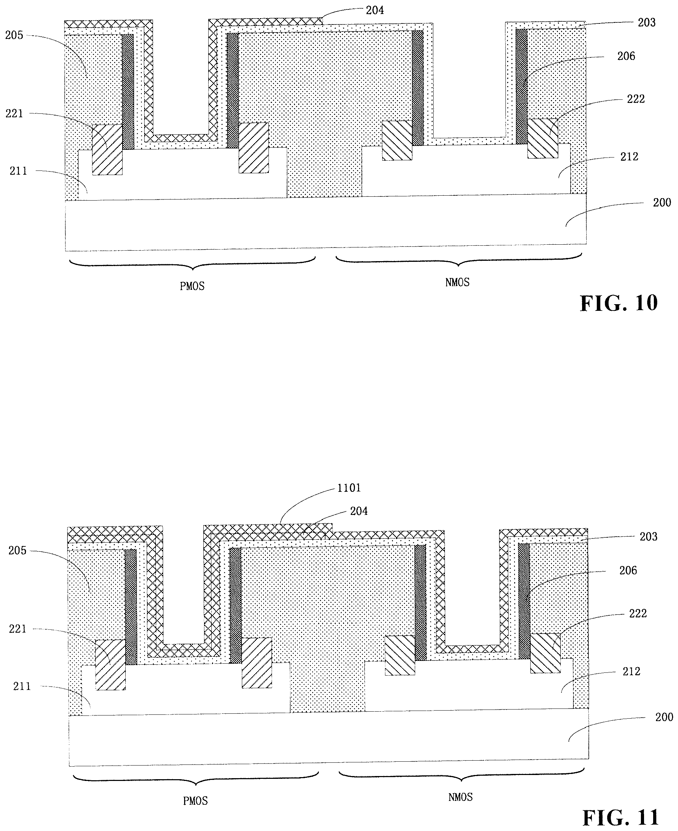

Next, in step 116, the portion of second protective layer 302 and the portion of first protective layer 301 on the PMOS region are removed, as shown in FIG. 10. The portion of second protective layer 302 and the portion of first protective layer 301 on the PMOS region are removed using a wet etching process. In an exemplary embodiment, the portion of second protective layer 302 on the PMOS region may be removed using NH₄OH or TMAH as an etching solution. The portion of first protective layer 301 on the PMOS region is removed using a wet etching process, e.g., using dilute hydrofluoric acid (HF).

Thus, a method of manufacturing a semiconductor device according to one embodiment of the present invention has been described above. According to the method, when the mask layer on the NMOS region is removed using a dry etching process, the first protective layer may reduce the damage of the high-k dielectric layer caused by the dry plasma etching is reduced. When removing the mask layer on the PMOS region, the first and second protective layers may reduce the damage caused by the plasma dry etching to the high-k dielectric layer of the PMOS and NMOS regions, thus, improving the device performance.

FIGS. 11 through 14 are cross-sectional views of intermediate stages of subsequent processes according to the present invention.

Referring to FIG. 11, a second P-type work function adjustment layer 1101 is formed on the portion of first P-type work function adjustment layer 204 on the PMOS region and on the portion of high-k dielectric layer 203 on the NMOS region. Second P-type work function adjustment layer 1101 may include, but is not limited to, TiN, TaN, or TaC and has a thickness in the range between 10 Angstroms and 20 Angstroms, e.g., 15 Angstroms.

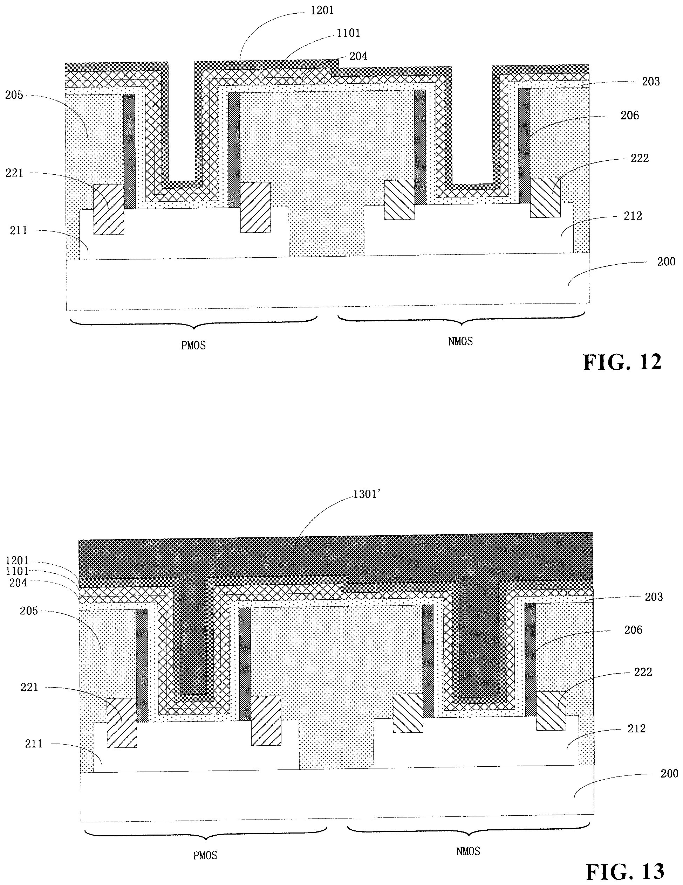

Referring to FIG. 12, an N-type work function adjustment layer 1201 is formed on second P-type work function adjustment layer 1101. N-type work function adjustment layer 1101 may include, but is not limited to, TiAl, TiCAl, TiNAl, or TiSiAl.

Referring to FIG. 13, a metal layer 1301' (e.g., tungsten) is deposited on N-type work function adjustment layer 1201 to form a metal electrode. In one embodiment, an adhesive layer, such as TiN, Ti or a stacked structure including TiN and Ti, is formed on N-type work function adjustment layer 1201. Thereafter, a metal layer 1301' is deposited on the adhesive layer, so that the bonding between metal layer 1301' and N-type work function adjustment layer 1201 is made more compact.

Thereafter, according to embodiments, a planarization (e.g., chemical mechanical polishing) process is performed on the metal layer to obtain a metal electrode 1301.

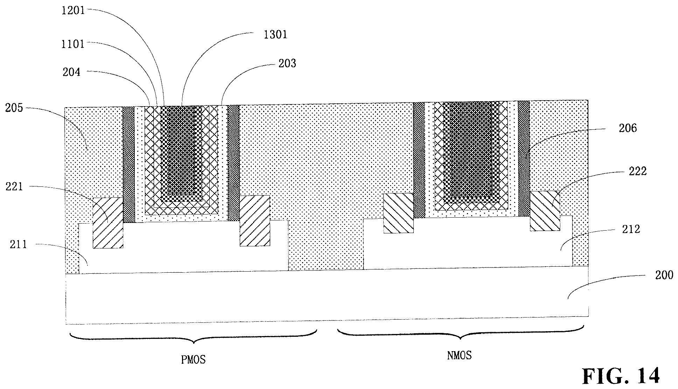

Referring to FIG. 14, a semiconductor device that can be obtained by a method according to the present invention includes a substrate structure including a PMOS region having a first trench and an NMOS region having a second trench on a substrate, a high-k dielectric layer at a bottom and on sidewalls of the first and second trenches, a first P-type work function adjustment layer on the high-k dielectric layer of the first and second trenches; a second P-type work function adjustment layer on the first P-type work function adjustment layer of the PMOS region; and an N-type work function adjustment layer on the second P-type work function adjustment layer of the PMOS region and on the first P-type work function of the NMOS region.

In one example, the first and second P-type work function adjustment layers each include TiN, TaN, or TaC. The N-type work function adjustment layer includes TiAl, TiCAl, TiNAl, or TiSiAl.

In one example, the semiconductor device further includes an interface layer formed between the bottom of the first and second trenches and the high-k dielectric layer.

In one example, the semiconductor device further includes a first semiconductor fin on the substrate; a second semiconductor fin on the substrate; raised source/drain regions on opposites sides of the first and second semiconductor fins.

In one example, the semiconductor device further includes spacers disposed between the raised source/drain regions and the first and second trenches.

In one example, the semiconductor device further includes a metal gate on the N-type work function adjustment layer of the first and second trenches.

In one example, the semiconductor device further includes an adhesive layer disposed between the metal gate and the N-type work function adjustment layer.

Embodiments of the present invention provide detailed description of a method for manufacturing a semiconductor device. In the description, numerous specific details such as forming a raised source/drain region, forming a protective layer by deposition, and the like have not been described in detail in order not to obscure the embodiments of the invention.

References in the specification to "one embodiment", "an embodiment", "an example embodiment", "some embodiments", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

While the present invention is described herein with reference to illustrative embodiments, this description is not intended to be construed in a limiting sense. Rather, the purpose of the illustrative embodiments is to make the present invention be better understood by those skilled in the art. In order not to obscure the invention, many details of well-known processes and manufacturing techniques are omitted. Various modifications of the illustrative embodiments as well as other embodiments will be apparent to those of skill in the art upon reference to the description. Such modifications are encompassed by the invention as far as they fall within the scope of the invention as defined by the appended claims.

Furthermore, some of the features of the preferred embodiments of the present invention could be used to advantage without the corresponding use of other features. As such, the foregoing description should be considered as merely illustrative of the principles of the invention, and not in limitation thereof.

## Claims

1. A method of manufacturing a semiconductor device, the method comprising:
first, providing (102) a substrate structure including a PMOS region having a first trench (201) and an NMOS region having a second trench (202), a high-k dielectric layer (203) at a bottom and on sidewalls of the first and second trenches (201, 202), and a first P-type work function adjustment layer (204) on the high-k dielectric layer (203);
thereafter, forming (104) a first protective layer (301) on the substrate structure and a second protective layer (302) on the first protective layer (301);
thereafter, forming (106) a mask layer (401) on the second protective layer (302);
thereafter, removing (108) the portion of the mask layer (401) which is on the NMOS region using a first dry etching process to expose the portion of the second protective layer (302) which is on the NMOS region;
thereafter, removing (110) the exposed portion of the second protective layer (302) on the NMOS region to expose the portion of the first protective layer (301) which is on the NMOS region;
thereafter, removing (112) the mask layer (401) on the PMOS region using a second dry etching process to expose the second protective layer (302) on the PMOS region;
thereafter, removing (114) the portion of the first protective layer (301) and the portion of the first P-type work function adjustment layer (204) which are on the NMOS region, the portion of the first protective layer (301) being removed by a wet etching process; and
thereafter, removing (116) the second protective layer (302) and the first protective layer (301) on the PMOS region by a wet etching process,
thereafter,
forming a second P-type work function adjustment layer (1101) on the portion of the first P-type work function adjustment layer (204) which is on the PMOS region and on the portion of the high-k dielectric layer (203) which is on the NMOS region:
forming an N-type work function adjustment layer (2101) on the second P-type work function adjustment layer (1101); and
forming a metal layer (1301') on the N-type work function adjustment layer (1201).

2. The method of claim 1, wherein at least one of:
the first protective layer (301) comprises silicon oxide and the second protective layer (302) comprises amorphous silicon or polycrystalline silicon; and
the substrate structure further comprises an interface layer formed between the bottom of the first and second trenches (201, 202) and the high-k dielectric layer (203).

3. The method of claim 2, wherein removing the respective portions of the first protective layer (301) on the
NMOS region and on the PMOS region comprises a dilute hydrofluoric acid (HF).

4. The method of anyone of the claims 2-3, wherein removing the respective portions of the second protective layer (302) on the NMOS region and on the PMOS region comprises an etching solution of NH4OH or TMAH.

5. The method of anyone of the claims 1-4, wherein the first trench (201) comprises a first semiconductor fin (211), and the second trench (202) comprises a second semiconductor fin (212), the method further comprising:
sequentially forming the high-k dielectric layer (203) and the first P-type work function adjustment layer (204) on an upper surface and on side surfaces of the first and second semiconductor fins (211, 212).

6. The method of anyone of the claims 1-5, wherein providing the substrate structure comprises:
providing an initial substrate structure including the PMOS region having the first trench (201) and the NMOS region having the second trench (202);
forming the high-k dielectric layer (203) at the bottom and on the sidewalls of the first and second trenches (201, 202);
forming a cap layer on the high-k dielectric layer (203), the cap layer comprising a TiN layer and an amorphous layer on the TiN layer; and
removing the cap layer to obtain the substrate structure.

7. The method of claim 1, wherein forming the metal layer (1301') on the N-type work function adjustment layer (1201) comprises:
forming an adhesive layer on the N-type work function adjustment layer (1201);
forming the metal layer (1301') on the adhesive layer.

8. The method of claim 1-7, further comprising:
planarizing the metal layer (1301') to form a metal gate.

9. The method of anyone of the claims 1-8, wherein at least one of:
the first P-type work function adjustment layer (204) comprises TiN, TaN, or TaC;
the second P-type work function adjustment layer (1101) comprises TiN, TaN, or TaC; and
the N-type work function adjustment layer (1201) comprises TiAl, TiCAl, TiNAl, or TiSiAl.

## Patentansprüche

1. Verfahren zur Herstellung eines Halbleiterbauelements, wobei das Verfahren aufweist:
zuerst Bereitstellen (102) einer Substratstruktur, die einen PMOS-Bereich mit einem ersten Graben (201) und einen NMOS-Bereich mit einem zweiten Graben (202), eine dielektrische Schicht (203) mit hohem k an einem Boden und auf Seitenwänden des ersten und zweiten Grabens (201, 202) und eine erste P-Typ-Arbeitsfunktionseinstellschicht (204) auf der dielektrischen Schicht (203) mit hohem k enthält;
danach Bilden (104) einer ersten Schutzschicht (301) auf der Substratstruktur und einer zweiten Schutzschicht (302) auf der ersten Schutzschicht (301);
danach Bilden (106) einer Maskenschicht (401) auf der zweiten Schutzschicht (302);
danach Entfernen (108) des Teils der Maskenschicht (401), der sich auf dem NMOS-Bereich befindet, unter Verwendung eines ersten Trockenätzprozesses, um den Teil der zweiten Schutzschicht (302) freizulegen, der sich auf dem NMOS-Bereich befindet;
danach Entfernen (110) des freigelegten Abschnitts der zweiten Schutzschicht (302) auf dem NMOS-Bereich, um den Abschnitt der ersten Schutzschicht (301) freizulegen, der sich auf dem NMOS-Bereich befindet
danach Entfernen (112) der Maskenschicht (401) auf dem PMOS-Bereich unter Verwendung eines zweiten Trockenätzprozesses, um die zweite Schutzschicht (302) auf dem PMOS-Bereich freizulegen;
danach Entfernen (114) des Teils der ersten Schutzschicht (301) und des Teils der ersten P-Typ-Arbeitsfunktionseinstellschicht (204), die sich auf dem NMOS-Bereich befinden, wobei der Teil der ersten Schutzschicht (301) durch einen Nassätzprozess entfernt wird; und
danach Entfernen (116) der zweiten Schutzschicht (302) und der ersten Schutzschicht (301) auf dem PMOS-Bereich durch einen Nassätzprozess;
danach Bilden einer zweiten P-Typ-Arbeitsfunktionseinstellschicht (1101) auf dem Teil der ersten P-Typ-Arbeitsfunktionseinstellschicht (204), der sich auf dem PMOS-Bereich befindet, und auf dem Teil der dielektrischen Schicht (203) mit hohem k, der sich auf dem NMOS-Bereich befindet;
Bilden einer N-Typ-Arbeitsfunktionseinstellschicht (2101) auf der zweiten P-Typ-Arbeitsfunktionseinstellschicht (1101); und
Bilden einer Metallschicht (1301') auf der N-Typ-Arbeitsfunktionseinstellschicht (1201).

2. Verfahren nach Anspruch 1, wobei mindestens eines von:
die erste Schutzschicht (301) Siliziumoxid aufweist und die zweite Schutzschicht (302) amorphes Silizium oder polykristallines Silizium aufweist; und
die Substratstruktur ferner eine Grenzflächenschicht aufweist, die zwischen dem Boden des ersten und des zweiten Grabens (201, 202) und der dielektrischen Schicht (203) mit hohem k ausgebildet ist.

3. Verfahren nach Anspruch 2, wobei das Entfernen der jeweiligen Abschnitte der ersten Schutzschicht (301) auf dem NMOS-Bereich und auf dem PMOS-Bereich eine verdünnte Fluorwasserstoffsäure (HF) aufweist.

4. Verfahren nach einem der Ansprüche 2 bis 3, wobei das Entfernen der jeweiligen Abschnitte der zweiten Schutzschicht (302) auf dem NMOS-Bereich und auf dem PMOS-Bereich eine Ätzlösung aus NH4OH oder TMAH aufweist.

5. Verfahren nach einem der Ansprüche 1-4, wobei der erste Graben (201) eine erste Halbleiterfinne (211) aufweist und der zweite Graben (202) eine zweite Halbleiterfinne (212) aufweist, wobei das Verfahren ferner aufweist:
Sequenzielles Bilden der dielektrischen Schicht (203) mit hohem k und der ersten P-Typ-Arbeitsfunktionseinstellschicht (204) auf einer oberen Oberfläche und auf Seitenoberflächen der ersten und zweiten Halbleiterfinne (211, 212).

6. Verfahren nach einem der Ansprüche 1 bis 5, wobei das Bereitstellen der Substratstruktur aufweist:
Bereitstellen einer anfänglichen Substratstruktur mit dem PMOS-Bereich mit dem ersten Graben (201) und dem NMOS-Bereich mit dem zweiten Graben (202);
Bilden der dielektrischen Schicht (203) mit hohem k am Boden und an den Seitenwänden des ersten und zweiten Grabens (201, 202);
Bilden einer Deckschicht auf der dielektrischen Schicht (203) mit hohem k, wobei die Deckschicht eine TiN-Schicht und eine amorphe Schicht auf der TiN-Schicht aufweist; und
Entfernen der Deckschicht, um die Substratstruktur zu erhalten.

7. Verfahren nach Anspruch 1, wobei das Bilden der Metallschicht (1301') auf der N-Typ-Arbeitsfunktionseinstellschicht (1201) aufweist:
Bilden einer Klebeschicht auf der N-Typ-Arbeitsfunktionseinstellschicht (1201);
Bilden der Metallschicht (1301') auf der Klebeschicht.

8. Verfahren nach Anspruch 1-7, ferner aufweisend:
Planarisieren der Metallschicht (1301') zur Bildung eines Metall-Gate.

9. Verfahren nach einem der Ansprüche 1-8, wobei mindestens eine von:
die erste P-Typ-Arbeitsfunktionseinstellschicht (204) TiN, TaN oder TaC aufweist;
die zweite P-Typ-Arbeitsfunktionseinstellschicht (1101) TiN, TaN oder TaC aufweist; und
die N-Typ-Arbeitsfunktionseinstellschicht (1201) TiAl, TiCAl, TiNAl oder TiSiAl aufweist.

## Revendications

1. Procédé de fabrication d'un dispositif à semiconducteurs, le procédé comprenant :
en premier lieu, la fourniture (102) d'une structure de substrat qui inclut une région PMOS qui comporte une première tranchée (201) et une région NMOS qui comporte une seconde tranchée (202), une couche diélectrique à k élevé (203) au niveau d'un fond et sur des parois latérales des première et seconde tranchées (201, 202), et une première couche de réglage de fonction de travail de type P (204) sur la couche diélectrique à k élevé (203) ;
ensuite, la formation (104) d'une première couche de protection (301) sur la structure de substrat et d'une seconde couche de protection (302) sur la première couche de protection (301) ;
ensuite, la formation (106) d'une couche de masque (401) sur la seconde couche de protection (302) ;
ensuite, la suppression (108) de la partie de la couche de masque (401) qui est sur la région NMOS en utilisant un premier processus de gravure par voie sèche afin d'exposer la partie de la seconde couche de protection (302) qui est sur la région NMOS ;
ensuite, la suppression (110) de la partie exposée de la seconde couche de protection (302) sur la région NMOS afin d'exposer la partie de la première couche de protection (301) qui est sur la région NMOS ;
ensuite, la suppression (112) de la couche de masque (401) sur la région PMOS en utilisant un second processus de gravure par voie sèche afin d'exposer la seconde couche de protection (302) sur la région PMOS ;
ensuite, la suppression (114) de la partie de la première couche de protection (301) et de la partie de la première couche de réglage de fonction de travail de type P (204) qui sont sur la région NMOS, la partie de la première couche de protection (301) étant supprimée au moyen d'un processus de gravure par voie humide ; et
ensuite, la suppression (116) de la seconde couche de protection (302) et de la première couche de protection (301) sur la région PMOS au moyen d'un processus de gravure par voie humide ;
ensuite, la formation d'une seconde couche de réglage de fonction de travail de type P (1101) sur la partie de la première couche de réglage de fonction de travail de type P (204) qui est sur la région PMOS et sur la partie de la couche diélectrique à k élevé (203) qui est sur la région NMOS ;
la formation d'une couche de réglage de fonction de travail de type N (2101) sur la seconde couche de réglage de fonction de travail de type P (1101) ; et
la formation d'une couche en métal (1301') sur la couche de réglage de fonction de travail de type N (1201).

2. Procédé selon la revendication 1, dans lequel au moins l'une des assertions qui suivent est satisfaite :
la première couche de protection (301) comprend de l'oxyde de silicium et la seconde couche de protection (302) comprend du silicium amorphe ou du silicium polycristallin ; et
la structure de substrat comprend en outre une couche d'interface qui est formée entre le fond des première et seconde tranchées (201, 202) et la couche diélectrique à k élevé (203).

3. Procédé selon la revendication 2, dans lequel la suppression des parties respectives de la première couche de protection (301) sur la région NMOS et sur la région PMOS comprend l'utilisation d'un acide fluorhydrique (HF) dilué.

4. Procédé selon l'une quelconque des revendications 2 et 3, dans lequel la suppression des parties respectives de la seconde couche de protection (302) sur la région NMOS et sur la région PMOS comprend l'utilisation d'une solution de gravure constituée par du NH₄OH ou du TMAH.

5. Procédé selon l'une quelconque des revendications 1 à 4, dans lequel la première tranchée (201) comprend une première ailette semiconductrice (211), et la seconde tranchée (202) comprend une seconde ailette semiconductrice (212), le procédé comprenant en outre :
la formation de façon séquentielle de la couche diélectrique à k élevé (203) et de la première couche de réglage de fonction de travail de type P (204) sur une surface supérieure et sur des surfaces latérales des première et seconde ailettes semiconductrices (211, 212).

6. Procédé selon l'une quelconque des revendications 1 à 5, dans lequel la fourniture de la structure de substrat comprend :
la fourniture d'une structure de substrat initiale qui inclut la région PMOS qui comporte la première tranchée (201) et la région NMOS qui comporte la seconde tranchée (202) ;
la formation de la couche diélectrique à k élevé (203) au niveau du fond et sur les parois latérales des première et seconde tranchées (201, 202) ;
la formation d'une couche de capuchon sur la couche diélectrique à k élevé (203), la couche de capuchon comprenant une couche en TiN et une couche amorphe sur la couche en TiN ; et
la suppression de la couche de capuchon afin d'obtenir la structure de substrat.

7. Procédé selon la revendication 1, dans lequel la formation de la couche en métal (1301') sur la couche de réglage de fonction de travail de type N (1201) comprend :
la formation d'une couche adhésive sur la couche de réglage de fonction de travail de type N (1201) ; et
la formation de la couche en métal (1301') sur la couche adhésive.

8. Procédé selon l'une quelconque des revendications 1 à 7, comprenant en outre :
la planarisation de la couche en métal (1301') afin de former une grille en métal.

9. Procédé selon l'une quelconque des revendications 1 à 8, dans lequel au moins l'une des assertions qui suivent est satisfaite :
la première couche de réglage de fonction de travail de type P (204) comprend du TiN, du TaN ou du TaC ;
la seconde couche de réglage de fonction de travail de type P (1101) comprend du TiN, du TaN ou du TaC ; et
la couche de réglage de fonction de travail de type N (1201) comprend du TiAI, du TiCAl, du TiNAI ou du TiSiAl.
